# EUROPÄISCHE PATENTSCHRIFT

(11) **EP 1 693 894 B1**
(45) Veröffentlichungstag und Bekanntmachung des Hinweises auf die Patenterteilung: **01.12.2010**
(21) Anmeldenummer: 05003689.6
(22) Anmeldetag: 21.02.2005
(51) Int. Cl.: H01L 27/15, H01L 51/40

(54) **Aktiv-Matrix-Struktur für eine Anzeigevorrichtung und Verfahren zu deren Herstellung**
Active matrix structure for display and manufacturing process thereof
Structure de matrice active pour dispositf d'affichage et son procédé de fabrication

(43) Veröffentlichungstag der Anmeldung: 23.08.2006
(73) Patentinhaber: Gigaset Communications GmbH, 81379 München (DE)
(72) Erfinder: Marwitz, Ludger, 46395 Bocholt (DE)
(74) Vertreter: Michalski Hüttermann & Partner Patentanwälte

(56) Entgegenhaltungen:
- EP-A- 0 838 846
- US-A- 5 082 793
- US-A- 5 376 561

## Beschreibung

Die Erfindung bezieht sich auf eine Aktiv-Matrix-Struktur für eine Anzeigevorrichtung sowie auf ein Verfahren zu deren Herstellung.

Bei der Herstellung von sog. Flachbildschirmen kommen Aktiv-Matrix-Strukturen zum Einsatz, die auf Polarisationseffekten von Flüssigkristallen beruhen. In diesem Zusammenhang sind sog. "Active Matrix LCD" bekannt, bei denen einzelne Pixel unter Verwendung von CMOS-Transistoren angesteuert werden.

Solchen bekannten Aktiv-Matrix-Strukturen ist es eigentümlich, dass sie hinsichtlich ihres Herstellungsverfahrens sehr komplex sind. Für die Verwirklichung einer Anzeigevorrichtung ist üblicher Weise eine Lichtquelle für eine Belichtung von rückwärts, ein Diffusor, ein Rückpolarisator, ein Matrix-Substrat mit einer Anzahl Reihen-Leitungen und einer Anzahl -Spaltenleitungen nebst zugehörigen Treibern, eine Flüssigkristallschicht, eine Farbfilterschicht und ein vorderer Polarisator erforderlich.

Aus dem Dokument US-A-5 376 561 ist ein Verfahren zur Herstellung eines elektronischen Schaltungsmoduls mit hoher Integrationsdichte bekannt, bei dem Schaltungsschichten auf jeweiligen Substraten ausgebildet werden, von denen anschließend die Schaltungsschicht auf dem einen Substrat auf die Schaltungsschicht des anderen Substrats übertragen wird unter Anordnen einer dazwischen liegenden Klebeschicht, und bei dem dann Öffnungen durch die dazwischenliegende Klebeschicht ausgebildet und Verbindungen zwischen den einzelnen Schaltungsschichten hergestellt werden.

Aus dem Dokument EP-A-0 838 846 A2 ist ein Verfahren zur Herstellung eines elektronischen Bauelements bekannt, bei dem auf zwei konträren Seiten eines Substrats zunächst ein Silikonnitrid- und ein Silikonoxidfilm aufgebracht und später wieder entfernt werden, wobei für das Aufbringen und das Entfernen der Filme spezielle Methoden verwendet werden.

Aus dem Dokument US-A-5 082 793 ist eine Produktionsmethode für eine Festkörperschaltungsstruktur bekannt, bei der durch Ionenimplantation dielektrischen Materials in die Struktur hinein PN-Schnittstellen oder andere aktive Regionen an vorgegebenen Verbindungsstellen geschaffen werden.

Ausgehend hiervon liegt der Erfindung die Aufgabe zugrunde, eine Aktiv-Matrix-Struktur für eine Anzeigevorrichtung sowie ein Verfahren zu ihrer Herstellung anzugeben, das gegenüber dem Stand der Technik vereinfacht ist.

Diese Aufgabe wird hinsichtlich des Verfahrens gelöst durch ein Verfahren nach Anspruch 1.

Dieses Verfahren zeichnet sich dadurch aus, dass, ausgehend von dem auch im Stand der Technik eingesetzten Matrix-Substrat, in lediglich drei nachfolgenden Verfahrensschritten eine Aktiv-Matrix-Struktur bereitgestellt werden kann. Die besondere Einfachheit des Verfahrens rührt daher, dass im Gegensatz zum Stand der Technik eine Lichtundurchlässigkeit der Aktiv-Matrix-Struktur in gewissem Maße in Kauf genommen werden kann, denn die Partikel elektronischer Tinte oder die optischen Leuchtdioden können allein bei Lichteinfall von außen einen gewünschten Text oder ein gewünschtes Bild darstellen, bzw. müssen nicht durchstrahlt werden.

Die Schritte b) und c) können bevorzugt durch Ionen-Implantation und anschließendem Laserglühen durchgeführt werden. Im Schritt c) werden Ionen implantiert, die eine erhöhte Elektronenleitung ermöglichen, während in einem nachfolgenden Teilschritt geeignete Ionen für eine erhöhte Löcherleitung implantiert werden. Für eine Homogenisierung sowohl des n⁺-dotierten Bereiches als auch des p⁺-dotierten Bereiches wird jeweils ein Laser-Glühschritt vorgenommen.

Der abschließende Verfahrensschritt d) kann vorsehen, dass die Schicht aus Matrix-Material auf die freie Oberfläche laminiert wird.

Ergebnis des Verfahrens ist eine Aktiv-Matrix-Struktur, die insbesondere auch biegsam sein kann, so dass flexible Anzeigevorrichtungen realisiert werden können.

Die o. g. Aufgabe wird hinsichtlich der Vorrichtung gelöst durch eine Aktiv-Matrix-Struktur für eine Anzeigeeinrichtung nach Anspruch 4.

Diese Aktiv-Matrix-Struktur ergibt sich als Erzeugnis des vorher erläuterten Herstellungsverfahrens.

Das vorgestellte Verfahren ist geeignet für besonders kostengünstige Anzeigevorrichtungen. Es werden keine Widerstände benötigt, wobei nur sehr wenige und einfache Verfahrensschritte durchzuführen sind, ohne dass Fotolithographieverfahren zum Einsatz kommen müssen.

Die Erfindung wird nachfolgend anhand eines Ausführungsbeispiels noch näher erläutert. Dabei wird Bezug auf die Zeichnungen genommen. Es zeigen:
- Figur 1: einen Pixelbereich einer Aktiv-Matrix-Struktur in einer ersten Verfahrensstufe,
- Figur 2: den Pixelbereich von Figur 1 in einer zweiten Verfahrensstufe,
- Figur 3: den Pixelbereich von Figur 1 in einer dritten Verfahrensstufe,
- Figur 4: den Pixelbereich von Figur 1 in einer Endverfahrensstufe und
- Figur 5: ein Ersatzschaltbild für zwei Pixelbereiche der Aktiv-Matrix-Struktur.

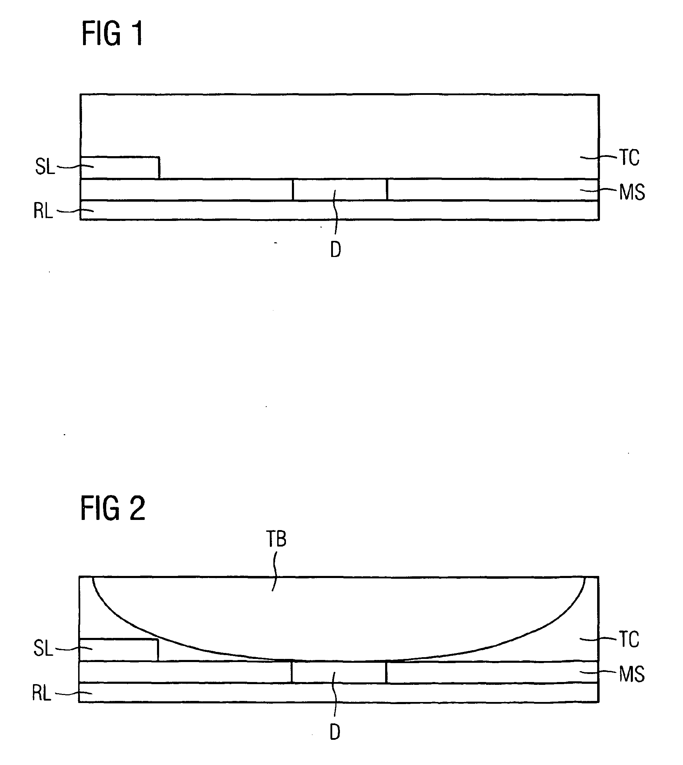

Der in Figur 1 veranschaulichte Pixelbereich zeigt als Ausgangspunkt des Herstellungsverfahrens ein Matrix-Substrat MS, beispielsweise aus "PET" (Polyesterterephthalat), bei dem es sich um ein flexibles Material handelt. Auf einer Unterseite des Matrix-Substrats MS ist eine Vielzahl von Reihen-Leitungen RL vorgesehen, von denen in den Figuren 1 bis 4 jeweils nur eine gezeigt ist. Auf einer Oberseite des Matrix-Substrats MS sind senkrecht zu den Reihen-Leitungen RL verlaufende Spalten-Leitungen SL vorgesehen. Zum Definieren von Pixeln ist jeweils eine Durchführung D vorgesehen, und zwar in dem Matrix-Substrat MS. Die Durchführung D ist mit einem Material gefüllt, so dass sich ein Widerstand von ca. 1 kΩ bis 10 kΩ ergibt.

Auf dem Matrix-Substrat MS wird eine Schicht aus p-Silizium TC abgeschieden, und zwar bis zu einer Dicke von ca. einigen µm bis ca. 0,1 mm. Die Spaltenleitungen SL liegen somit innerhalb der Schicht aus p-Silizium TC.

Wie in Figur 2 veranschaulicht ist, werden in einem nächsten Verfahrensschritt Ionen in die Schicht aus p-Silizium TC implantiert, wobei die Ionen derart geladen sind, dass sich ein n⁺-dotierter Bereicht TB ausbildet, der von der Durchführung ausgeht, sich dann zu allen Seiten der Durchführung verbreitert, bis er eine freie Oberfläche der Schicht aus p-Silizium TC erreicht hat. Es wird für eine Dotierung/Restrukturierung des Gitters ein Laser-Glüh-Verfahrensschritt vorgenommen, und zwar für den n⁺-dotierten Bereich TB. Ein Laser-Glühen kann beispielsweise mit Hilfe eines XeCl-Excimerlasers in gepulster Betriebsart vorgenommen werden. Bei einer Wellenlänge von 308 mm und einer Pulsdauer von etwa 35 ms werden dünne amorphe Siliziumschichten, im vorliegenden Fall die Schicht aus p-Silizium TC kristallisiert und dotiert, ohne das darunter liegende Matrix-Substrat aufzuheizen. Das p-Silizium bleibt etwa 20 bis 250 ns in einem geschmolzenen Zustand, was von dem Laserenergiefluss abhängt, der typischer Weise 150 bis 350 mJ/cm² beträgt. Sowohl n- als auch p-Dotierung kann unter Verwendung von zuvor in einem Plasma abgeschiedenen Filmen einer Dicke von etwa 30 Å mit Dotierungsmaterial durchgeführt werden. Die sehr dünnen abgeschiedenen Filme werden mit dem darunter liegenden p-Silizium gemischt, und zwar während eines Prozesses, bei dem das Silizium geschmolzen wird und eine Kristallstruktur neu wächst. Dieser Prozess wird von dem Laserpuls ausgelöst.

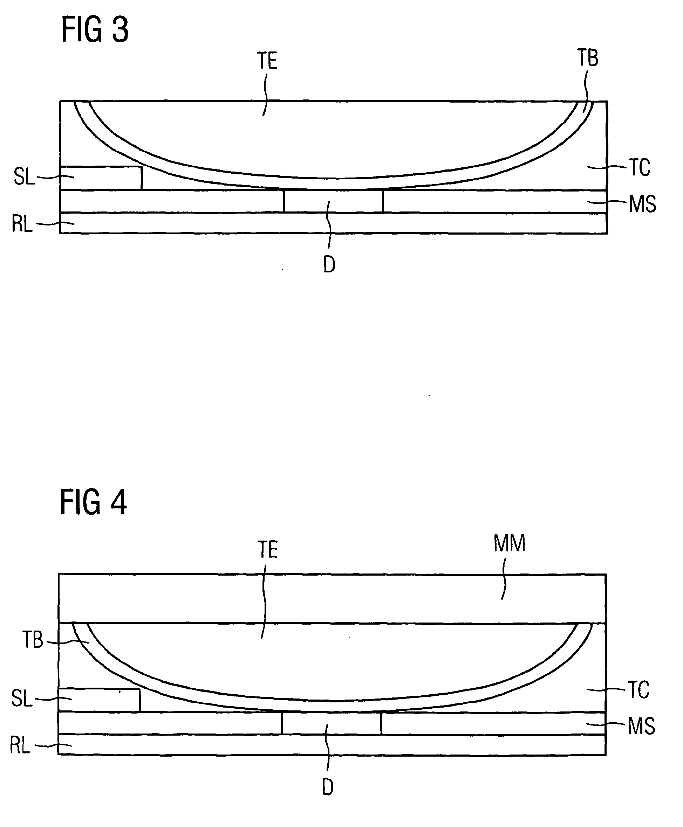

In einem dritten Verfahrensschritt, der anhand der Figur 3 veranschaulicht ist, wird innerhalb des n⁺-dotierten Bereiches TB ein p⁺-dotierter Bereich TE ausgebildet, wiederum durch Ionen-Implantation und Laser-Glühen. Es verbleibt eine etwa schalenförmige Schicht für den n⁺⁻dotierten Bereich TB, während ein Innenbereich der n⁺⁻dotierten Schicht TB durchgehend p⁺-dotiert ist.

In einem abschließenden Verfahrensschritt wird ein Matrix-Material MM, das darin enthaltene Partikel elektronischer Tinte aufweist, auf eine freie Oberfläche der Endstruktur des vorhergehenden Verfahrensschritts laminiert. Insgesamt entsteht eine Halbleiter-Struktur, die von ihren elektrischen Eigenschaften her einem Bipolar-Transistor vergleichbar ist. Dabei bildet ein verbliebener Bereich der des p-Siliziums TC in der Nähe einer Spalten-Leitung SL einen Kollektor. Die n⁺⁻dotierte Schicht TB ist die Basis, während der p⁺-dotierte Bereich TE als Emitter wirkt und gleichzeitig auch als Pixelkapazität.

Das Matrix-Material MM kann auch als sog. "elektronisches Papier" bezeichnet werden, so dass sämtliche Schichten der Aktiv-Matrix-Struktur für eine Anzeigevorrichtung eine gewisse Flexibilität zeigen. Auf diese Weise wird es ermöglicht, beispielsweise aufrollbare Aktiv-Matrix-Strukturen bereitzustellen.

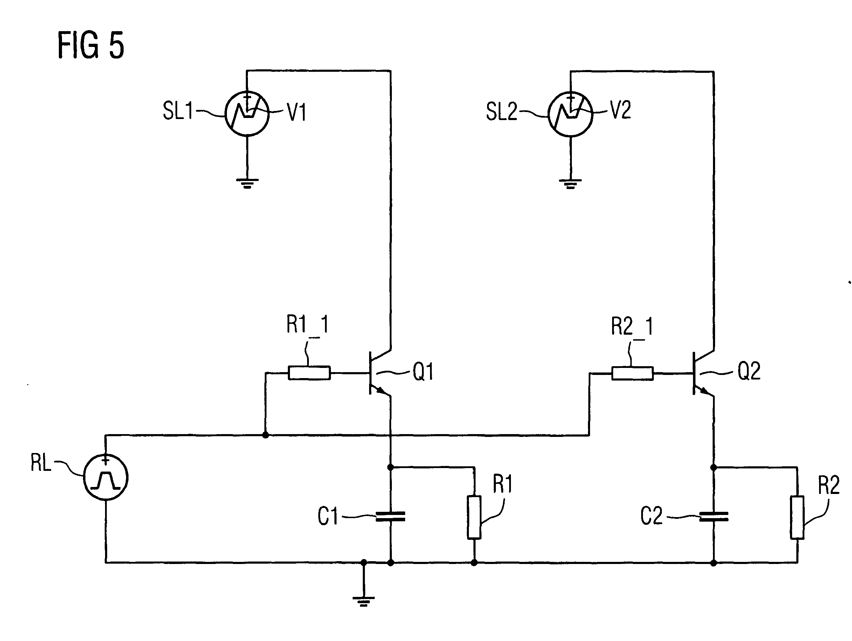

Anhand der Figur 5 wird nunmehr erläutert, auf welche Weise ein Pixel angesteuert wird. Die Figur 5 bezieht sich auf einen Teil der Aktiv-Matrix-Struktur mit zwei Pixelbereichen, die beide derselben Reihen-Leitung RL aber verschiedenen Spalten-Leitungen SL1, SL2 zugeordnet sind.

An der Reihenleitung RL liegt ein Steuerpuls mit einer Spannung V0 an, während an den beiden Spaltenleitungen SL1, SL2 jeweils die Spannungen V1 und V2 vorgesehen sind. Dies bedeutet, dass in der Figur 4 an der Reihen-Leitung RL die Spannung V0 und an der Spalten-Leitung SL1 beispielsweise die Spannung V1 vorhanden ist. Jedes Pixel umfasst schaltungstechnisch einen Bipolar-Transistor Q1, dessen Emitter von dem p⁺-dotierten Bereich TE, dessen Basis von dem n⁺-dotierten Bereich TB und dessen Kollektor von dem p-Silizium zwischen dem n⁺-dotierten Bereich TB und der Spalten-Leitung SL gebildet wird. Der n⁺-dotierte, die Basis bildende Bereich TB ist über ein Widerstand R1, der von der Durchführung D und der Zuleitung herrührt, mit der Reihen-Leitung RL verbunden. Der p⁺-dotierte Siliziumbereich TC grenzt an die Spalten-Leitung SP an. Der Emitter, entsprechend dem n⁺-dotierten Bereich TE, bildet durch seine Sperrschicht und die Pixelkapazität den Kondensator C1, der mit Masse verbunden ist. Ein parallel zu dem Kondensator C1 geschalteter Widerstand R1 versinnbildlicht vorhandene Leckströme.

Ein Bipolar-Transistor Q2, ein Widerstand R21 zur Reihen-Leitung RL, eine Kapazität C2, und ein Widerstand R2 veranschaulichen ein zweites Pixel. Bei diesem zweiten Pixel ist ein Kollektorbereich mit einer zweiten Spalten-Leitung SL2 verbunden, während die übrigen Schaltungsteile denjenigen des ersten Pixels entsprechen.

Ein kurzer Spannungspuls von beispielsweise zwei µs Länge für die Spannung V0 bewirkt nun, dass die Spannung V1 bzw. V2 an einem jeweiligen Kondensator C1, C2 anliegt. Eine vorhandene Ladung an dem Kondensator C1 oder C2 bewirkt, dass die Partikel elektronischer Tinte, die aus zwei Halbkugeln, die eine weiß, die andere schwarz gebildet sein können, wie gewünscht ausgerichtet werden, so dass eine bildliche Darstellung eines gewünschten Textes ermöglicht wird. Die beiden Halbkugeln sind elektrisch verschieden geladen, so dass eine Ladespannung der Kondensatoren C1, C2 deren Ausrichtung innerhalb des Matrix-Materials bestimmen kann. Alternativ kann die Ladung von C1, C2 zur Ansteuerung von OLED-Pixeln genutzt werden.

Trotz der Verwendung von Bipolar-Technologie kann davon ausgegangen werden, dass die sich ergebende Aktiv-Matrix-Struktur energieeffizient ist. Dies liegt daran, dass jeder Transistor Q1, Q2 eine Last in Form der Kapazitäten C1, C2 treibt, die, verglichen mit der Eingangslast eines digitalen Schaltkreises, groß ist. Experimentelle Untersuchungen des Erfinders haben gezeigt, dass ein Basisstrom für Pixel, deren Ladung geändert wird, gering ist, während der Basisstrom bei ungeänderter Pixelspannung sehr niedrig ist.

## Patentansprüche

1. Verfahren zur Herstellung einer Aktiv-Matrix-Struktur für eine Anzeigevorrichtung, mit den Schritten:
a) Bereitstellen eines Matrix-Substrats (MS) mit einer Anzahl Reihen-Leitungen (RL) und einer Anzahl Spalten-Leitungen (SL), wobei jedem Schnittpunkt zwischen einer der Reihen-Leitungen (RL) und einer der Spalten-Leitungen (SL) eine mit einem elektrisch leitenden Material gefüllte Durchführung (D) durch das Matrix-Substrat (MS) zur Erzeugung eines Pixels zugeordnet ist,
b) Abscheiden einer Schicht aus p-Silizium (TC) auf dem Matrix-Substrat (MS),
c) Für jedes Pixel Erzeugen eines n⁺-dotierten Bereiches (TB) in dem p-Silizium (TC), der von der Durchführung (D) aus bis zu einer freien Oberfläche der Schicht aus p-Silizium (TC) vorgesehen wird, und Erzeugen eines p-dotierten Bereiches (TE) innerhalb des n⁺-dotierten Bereiches (TB) derart, dass von dem n⁺-dotierten Bereich (TB) eine Schicht verbleibt und der p⁺-dotierte Bereich (TE) bis zu einer freien Oberfläche des n⁺-dotierten Bereichs (TB) reicht, und
d) Aufbringen einer Schicht aus einem Matrix-Material (MM) mit darin enthaltenen, als elektronische Tinte genutzten Partikeln, oder Aufbringen einer organischen Leuchtdioden-Schicht auf die freie Oberfläche des p⁺-dotierten Bereiches (TE).

2. Verfahren nach Anspruch 1,
bei dem
die Schritte b) und c) durch Ionen-Implantation und anschließendes Laser-Glühen durchgeführt werden.

3. Verfahren nach einem der Ansprüche 1 oder 2,
bei dem
in Schritt d) die Schicht aus Matrix-Material (MM) auf die freie Oberfläche des p⁺-dotierten Bereiches (TE) laminiert wird.

4. Aktiv-Matrix-Struktur für eine Anzeigeeinrichtung, mit einem Matrix-Substrat (MS), das eine Anzahl Reihen-Leitungen (RL) und eine Anzahl Spalten-Leitungen (SL) aufweist, wobei jedem Schnittpunkt zwischen einer der Reihen-Leitungen (RL) und einer der Spalten-Leitungen (SL) eine Durchführung (D) durch das Matrix-Substrat (MS) zur Erzeugung eines Pixels zugeordnet ist, **dadurch gekennzeichnet, dass** eine jede Durchführung (D) mit einem elektrisch leitenden Material gefüllt ist, dass eine Schicht aus p-Silizium (TC) auf dem Matrix-Substrat (MS) vorgesehen ist, wobei für jedes Pixel in der Schicht aus p-Silizium (TC) ein n⁺-dotierter Bereich (TB) vorgesehen ist, der von der Durchführung (D) aus bis zu einer gegenüberliegenden Oberfläche der Schicht aus p-Silizium (TC) reicht, und wobei innerhalb jedes n⁺-dotierten Bereiches (TB) ein p⁺-dotierter Bereich (TE) eingebeltet ist, der von dem n⁺-dotierten Bereich (TB) eine Schicht übriglässt und bis zu einer freien Oberfläche des n⁺-dotierten Bereichs (TB) reicht, und dass eine Schicht aus einem Matrix-Material (MM) mit darin enthaltenen, als elektronische Tinte genutzten Partikeln, oder eine organische Leuchtdiodenschicht auf der freien Oberfläche des p⁺-dotierten Bereiches (TE) vorgesehen ist.

## Claims

1. Method for producing an active matrix structure for a display device, comprising the following steps:
a) providing a matrix substrate (MS) having a number of row lines (RL) and a number of column lines (SL), each point of intersection between one of the row lines (RL) and one of the column lines (SL) being assigned a feedthrough (D), filled with an electrically conductive material, through the matrix substrate (MS) for producing a pixel,
b) depositing a layer composed of p-silicon (TC) on the matrix substrate (MS),
c) for each pixel producing an n⁺-doped region (TB) in the p-silicon (TC), said region being provided from the feedthrough (D) as far as a free surface of the layer composed of p-silicon (TC) and producing a p-doped region (TE) within the n⁺-doped region (TB) in such a way that a layer of the n⁺-doped region (TB) remains and the p⁺-doped region (TE) extends as far as a free surface of the n⁺-doped region (TB), and
d) applying a layer composed of a matrix material (MM) with particles that are contained therein and are utilized as electronic ink, or applying an organic light-emitting diode layer to the free surface of the p⁺-doped region (TE).

2. Method according to Claim 1,
wherein
steps b) and c) are carried out by ion implantation and subsequent laser annealing.

3. Method according to either of Claims 1 and 2,
wherein
in step d) the layer composed of matrix material (MM) is laminated onto the free surface of the p⁺-doped region (TE).

4. Active matrix structure for a display device, comprising a matrix substrate (MS) having a number of row lines (RL) and a number of column lines (SL), each point of intersection between one of the row lines (RL) and one of the column lines (SL) being assigned a feedthrough (D) through the matrix substrate (MS) for producing a pixel, **characterized in that** each feedthrough (D) is filled with an electrically conductive material, **in that** a layer composed of p-silicon (TC) is provided on the matrix substrate (MS), wherein for each pixel, an n⁺-doped region (TB) is provided in the layer composed of p-silicon (TC), said region extending from the feedthrough (D) as far as an opposite surface of the layer composed of p-silicon (TC), and wherein there is embedded within each n⁺-doped region (TB) a p⁺-doped region (TE) which leaves free a layer of the n⁺-doped region (TB) and extends as far as a free surface of the n⁺-doped region (TB), and **in that** provision is made of a layer composed of a matrix material (MM) with particles that are contained therein and are utilized as electronic ink, or an organic light-emitting diode layer on the free surface of the p⁺-doped region (TE).

## Revendications

1. Procédé de fabrication d'une structure à matrice active pour dispositif d'affichage, le procédé comprenant les étapes qui consistent à :
a) préparer un substrat de matrice (MS) qui présente plusieurs conducteurs de ligne (RL) et plusieurs conducteurs de colonne (SL), un passage (D) rempli d'un matériau électriquement conducteur et traversant le substrat en matrice (MS) étant associé à chaque point d'intersection entre un des conducteurs de ligne (RL) et un des conducteurs de colonne (SL) pour former un pixel,
b) dépôt d'une couche de silicium p (TC) sur le substrat en matrice (MS),
c) pour chaque pixel, formation d'une zone à dopage n⁺ (TB) dans le silicium p (TC), la zone étant prévue depuis le passage (D) jusqu'à une surface libre de la couche en silicium p (TC), et formation d'une zone (TE) à dopage p à l'intérieur de la zone (TB) à dopage n⁺ de telle sorte qu'une couche de la zone (TB) à dopage n⁺ reste et que la zone (TE) à dopage p⁺ s'étende jusqu'à la surface libre de la zone (TB) à dopage n⁺ et
d) application d'une couche d'un matériau de matrice (MM) qui contient des particules utilisées comme encre électronique ou application d'une couche de diode luminescente organique sur la surface libre de la zone (TE) à dopage p⁺.

2. Procédé selon la revendication 1, dans lequel les étapes b) et c) sont réalisées par implantation d'ions et sont suivies d'un recuit au laser.

3. Procédé selon l'une des revendications 1 ou 2, dans lequel la couche de matériau de matrice (MM) est stratifiée sur la surface libre de la zone (TE) à dopage p⁺ au cours de l'étape d).

4. Structure de matrice active pour dispositif d'affichage, qui présente un substrat de matrice (MS) qui présente plusieurs conducteurs de ligne (RL) et plusieurs conducteurs de colonne (SL), un passage (D) rempli d'un matériau électriquement conducteur et traversant le substrat en matrice (MS) étant associé à chaque point d'intersection entre un des conducteurs de ligne (RL) et un des conducteurs de colonne (SL) pour former un pixel, **caractérisée en ce que** chaque passage (D) est rempli d'un matériau électriquement conducteur, **en ce qu'**une couche (TC) de silicium p est prévue sur le substrat en matrice (MS), une zone (TB) à dopage n⁺ étant prévue pour chaque pixel dans la couche (TC) de silicium p et s'étendant entre le passage (D) jusque dans une surface opposée de la couche (TC) en silicium p, et une zone (TE) à dopage p⁺ étant incorporée à l'intérieur de chaque zone (TB) à dopage n⁺ et une couche étant exempte de la zone (TB) à dopage n⁺ et s'étendant jusqu'à une surface libre de la couche (TB) à dopage n⁺ et **en ce qu'**une couche de matériau de matrice (MM) qui contient des particules utilisées comme encre électronique ou une couche de diode luminescente organique est prévue sur la surface libre de la zone (TE) à dopage p⁺.
